(19) Europäisches Patentamt
European Patent Office
Office européen des brevets

(11) **EP 3 321 151 B1**

(12) **EUROPEAN PATENT SPECIFICATION**

(45) Date of publication and mention
of the grant of the patent:
**20.03.2019 Bulletin 2019/12**

(51) Int Cl.:
**B62D 15/02** (2006.01)   **G01D 5/04** (2006.01)
**G01D 5/14** (2006.01)

(21) Application number: **17200380.8**

(22) Date of filing: **07.11.2017**

(54) **STEERING ANGLE DETECTING APPARATUS**

LENKWINKELERFASSUNGSVORRICHTUNG

APPAREIL DE DÉTECTION D'ANGLE DE DIRECTION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **09.11.2016 KR 20160148762**

(43) Date of publication of application:
**16.05.2018 Bulletin 2018/20**

(73) Proprietor: **LS Automotive Technologies Co., Ltd.
Danwon-gu, Ansan-si,
Gyeonggi-do 15611 (KR)**

(72) Inventors:
• **KIM, Tae-Woo
08298 Seoul (KR)**

• **NA, Byung-Cheol
15822 Gunpo-si, Gyeonggi-do (KR)**
• **SHIN, Jin-Kyu
18439 Hwaseong-si, Gyeonggi-do (KR)**
• **JUNG, Tae-Hong
07359 Seoul (KR)**
• **CHOI, Yeon-Muk
18414 Hwaseong-si, Gyeonggi-do (KR)**

(74) Representative: **Schumacher & Willsau
Patentanwaltsgesellschaft mbH
Nymphenburger Straße 42
80335 München (DE)**

(56) References cited:
**EP-A2- 1 477 389    KR-A- 20120 014 780**

**Description**

TECHNICAL FIELD

The present disclosure relates to a steering angle detecting apparatus, and more particularly, to a steering angle detecting apparatus, which detects a rotation angle of a steering wheel of a vehicle.

BACKGROUND ART

A steering device, which is essentially applied to a vehicle, is a device for changing the path and direction of the vehicle according to a driver's request. The steering device basically includes a steering wheel operated by the driver, a steering shaft associated with the steering wheel to transmit the operating force, and a steering angle detecting device mounted to the steering shaft to detect a steering angle of the steering wheel.

Among them, the steering angle detecting device generally employs a magnetic-type device using an anisotropic magneto resistive (AMR) sensor. In the magnetic-type device, a plurality of sub gears respectively having a magnet inserted therein is engaged with and coupled to a main gear connected to a steering shaft, and then the change of magnetic field according to the rotation of the sub gears is measured to calculate the rotation angle of the steering wheel.

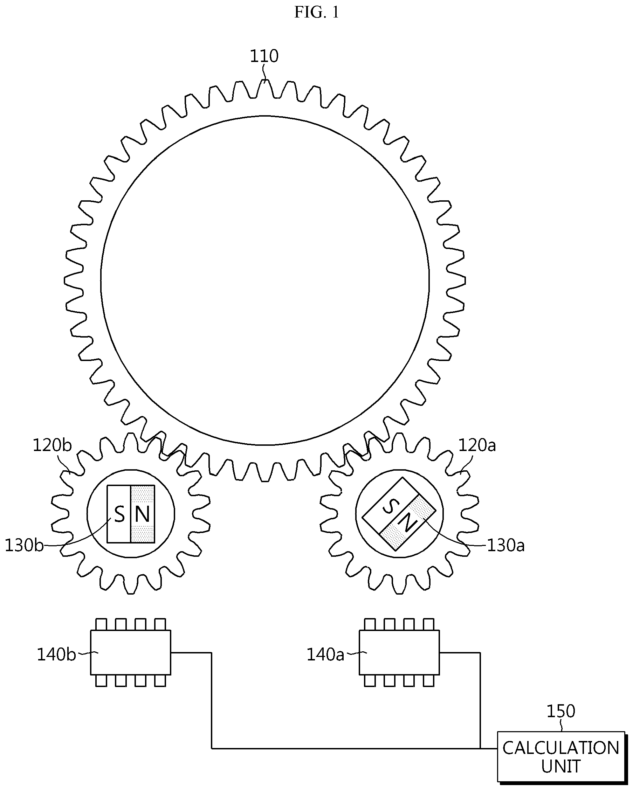

FIG. 1 is a schematic view showing a general steering angle detecting device according to the prior art.

As shown in FIG. 1, the general steering angle detecting device according to the prior art includes a single main gear 110 through which a steering shaft (not shown) of a vehicle is coupled so that the single main gear 110 integrally rotates together with the steering shaft, and first and second sub gears 120a, 120b rotating in engagement with the main gear 110. First and second magnets 130a, 130b are respectively coupled to the first and second sub gears 120a, 120b to integrally rotate together with the first and second sub gears 120a, 120b, and first and second sensors 140a, 140b are mounted to outer sides of the first and second sub gears 120a, 120b to detect the change of magnetic field of the first and second magnets 130a, 130b. At this time, the first and second sensors 140a, 140b uses an anisotropic magneto resistive (AMR) sensor.

Thus, if a driver turns the steering wheel (not shown) so that the steering shaft rotates, the main gear 110 rotates, and accordingly the first and second sub gears 120a, 120b and the first and second magnets 130a, 130b rotate. The change of magnetic field caused by the rotation of the first and second magnets 130a, 130b is detected by the first and second sensors 140a, 140b, and each detection signal is transmitted to a calculation unit 150 so that a rotation angle of the steering wheel is calculated using a separate algorithm.

DISCLOSURE

Technical Problem

The inventors of the present disclosure have found that in the magnetic-type steering angle detecting device as described above, the arrangement of a main gear and two sub gears gives a great influence on the performance.

Thus, the present disclosure is directed to providing a steering angle detecting apparatus, which may reduce an error rate in the measurement of a rotation angle by optimizing the arrangement of a main gear and two sub gears.

EP 1 477 389 discloses the preamble of claim 1.

Technical Solution

In one aspect of the present disclosure, there is provided a steering angle detecting apparatus, which detects a rotation angle of a steering wheel, the apparatus comprising: a main gear configured to rotate in association with a steering shaft connected to the steering wheel; and two sub gears respectively having a magnet and configured to rotate in engagement with the main gear, wherein a triangle obtained by connecting centers of the main gear and the two sub gears has an area of 334 mm$^2$ or above and 528 mm$^2$ or below.

Preferably, a distance between the centers of the main gear and any one sub gear of two sub gears may be 27 mm or above and 38 mm or below, and a distance between the centers of the main gear and another sub gear of the plurality of sub gears may be 27.5 mm or above and 38.5 mm or below.

More preferably, a distance between the centers of two sub gears may be 25 mm or above and 35 mm or below.

Advantageous Effects

According to an embodiment, an error rate in the measurement of a rotation angle of a steering wheel is reduced by optimizing the arrangement of a main gear and two sub gears.

The steering angle detecting apparatus according to an embodiment may enhance the accuracy of a vehicle driver in operating a steering wheel.

DESCRIPTION OF DRAWINGS

FIG. 1 is a schematic view showing a general steering angle detecting device according to the prior art.
FIG. 2 is a diagram for illustrating an engagement structure of a main gear and two sub gears, employed at a steering angle detecting apparatus according to an embodiment.
FIG. 3 is a diagram showing a distance between centers of two engaged gears according to an embodiment.
FIG. 4 is a diagram showing a test environment of the steering angle detecting apparatus according to an embodiment.
FIG. 5 is a graph of Table 2.

BEST MODE

The above objects, features and advantages of the present disclosure will become apparent from the following descriptions of the embodiments with reference to the accompanying drawings, from which it will be deemed that a person having ordinary skill can easily practice the technical features of the present disclosure. Also, any explanation of the prior art known to relate to the present disclosure may be omitted if it is regarded to render the subject matter of the present disclosure vague. Hereinafter, an embodiment of the present disclosure will be described in detail with reference to the accompanying drawings.

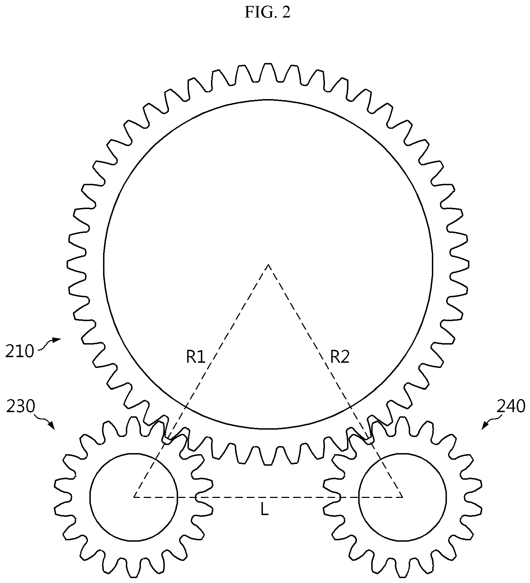

FIG. 2 is a diagram for illustrating an engagement structure of a main gear 210 and two sub gears 230, 240, employed at a steering angle detecting apparatus according to an embodiment. In an embodiment, two sub gears 230, 240 are symmetrically disposed to have a stable detection function. A magnet is installed at the inside of each sub gear 230, 240. In addition, a magnetic sensor is installed at an outer side of each sub gear 230, 240, preferably with a predetermined distance from the magnet of each sub gear 230, 240 in a vertical direction, to face the magnet. If the main gear 210 rotates according to the rotation of the steering shaft, two sub gears 230, 240 engaged with the main gear 210 also rotate, and at this time, the change of magnetic field caused by the magnets of two sub gears 230, 240 is detected by the magnetic sensor.

Generally, as two gears rotating in engagement with each other have a larger size, the backlash increases and thus the contact ratio is greatly deteriorated. The backlash is a gap created between surfaces of two teeth when two gears are engaged. Thus, if the main gear 210 and two sub gears 230, 240 of the steering angle detecting apparatus have a greater size, a measurement error rate of the steering angle increases due to the deterioration of the contact ratio. The inventors of the present disclosure have endeavored to reduce the size of the main gear 210 and two sub gears 230, 240 in order to decrease the backlash and improve the contact ratio. However, it has been found that the measurement error rate of the steering angle is still not reduced to a meaningful level. The inventors of the present disclosure though that if the size of the main gear 210 and two sub gears 230, 240 is reduced, the distance between two sub gears 230, 240 decreases to generate interference of magnetic fields between the magnets installed at the sub gears 230, 240, which causes an error in the measurement value of the steering angle. Thus, the inventors have attempted to increase the distance between the sub gears 230, 240 while maintaining the size of the main gear 210 and the sub gears 230, 240, but it was found that the measurement error rate of the rotation angle was not reduced in proportion thereto. After many efforts, the inventors found that the size of the gears 210, 230, 240 and the distance between two sub gears 230, 240 having magnets comprehensively affect the error rate. In other words, the inventors found that a triangle obtained by connecting center points of the gears 210, 230, 240 gives a direct effect on the error rate.

Referring to FIG. 2, an area A of the triangle obtained by connecting the center points of the gears 210, 230, 240 is calculated using Equation 1 below.

Equation 1

$$A = \sqrt{s(s - R1)(s - R2)(s - L)}, \quad \text{where} \quad s = \frac{R1 + R2 + L}{2}$$

R1 represents a distance between the centers of the main gear 210 and the sub gear 230, R2 represents a distance between the centers of the main gear 210 and the sub gear 240, and L represents a distance between the centers of two sub gear 230, 240.

3

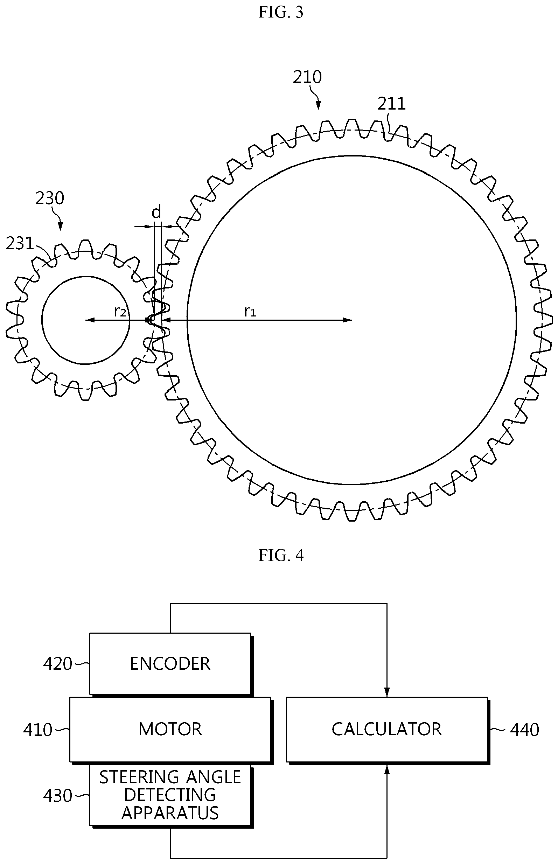

FIG. 3 is a diagram showing a distance between centers of two engaged gears according to an embodiment and depicts a distance between the centers of the main gear 210 and the sub gear 230. Referring to FIG. 3, the distance between the centers of the main gear 210 and the sub gear 230 is a sum of a radius $r_1$ of a pitch circle 211 of the main gear 210, a radius $r_2$ of a pitch circle 231 of the sub gear 230, and a shortest distance d between two pitch circles 211, 231. A distance between the centers of the main gear 210 and the sub gear 240 is also calculated in the same way.

If the area A of the triangle obtained by connecting the center points of three gears 210, 230, 240 of steering angle detecting apparatus as described above is 334 mm$^2$ or above and 528 mm$^2$ or below, the measurement error rate of the steering angle is reduced to a meaningful level. At this time, the distance R1 between the centers of the main gear 210 and the sub gear 230 is preferably 27 mm or above and 38 mm or below. In addition, the distance R2 between the centers of the main gear 210 and the sub gear 240 is preferably 27.5 mm or above and 38.5 mm or below. In addition, the distance L between the centers of the sub gear 230 and the sub gear 240 is preferably 25 mm or above and 35 mm or below.

Hereinafter, the result of the performance experiment of the steering angle detecting apparatus according to the area A of the triangle obtained by connecting the center points of three gears 210, 230, 240 will be described.

Preparation of a sample

Ten steering angle detecting apparatuses were prepared so that the area A of the triangle obtained by connecting the center points of three gears 210, 230, 240 is different from each other. The distance between the centers of the gears 210, 230, 240 of ten steering angle detecting apparatuses and the area A of the triangle obtained by connecting the center points of the gears 210, 230, 240 are as in Table 1 below.

Table 1

|  | R1 (mm) | R2 (mm) | L (mm) | A (mm$^2$) |
|---|---|---|---|---|
| Comparative Example 1 | 24 | 24.5 | 24 | 253 |
| Comparative Example 2 | 25 | 25.5 | 27 | 288 |
| Comparative Example 3 | 26 | 26.5 | 32 | 333 |
| Example 1 | 27 | 27.5 | 29 | 334 |
| Example 2 | 28 | 28.5 | 35 | 388 |
| Example 3 | 37 | 37.5 | 25 | 439 |
| Example 4 | 38 | 38.5 | 30 | 528 |
| Comparative Example 4 | 39 | 39.5 | 29 | 529 |
| Comparative Example 5 | 40 | 40.5 | 36 | 648 |
| Comparative Example 6 | 41 | 41.5 | 38 | 696 |

Seeing Table 1, the area A of the triangle increases from the first row to the last row. In Comparative Examples 1 to 3, the area A of the triangle obtained by connecting the center points of three gears 210, 230, 240 is lower than 334 mm$^2$. In Examples 1 to 4, the area A of the triangle obtained by connecting the center points of three gears 210, 230, 240 is 334 mm$^2$ or above and 528 mm$^2$ or below. In Comparative Examples 4 to 6, the area A of the triangle obtained by connecting the center points of three gears 210, 230, 240 is greater than 528 mm$^2$.

Measurement of performance

The performance was measured using a SAS (Steering Angle Sensor) Performance Tester. FIG. 4 is a diagram showing a test environment of the steering angle detecting apparatus according to an embodiment. As shown in FIG. 4, a steering angle detecting apparatus 430 is coupled to one end of a rotary shaft of a motor 410, and an encoder 420 is coupled to the other end of the rotary shaft. Here the rotary shaft of the motor 410 serves as a steering shaft of a vehicle, and the rotating speed is 100 rpm. A calculator 440 calculates three parameters by using an output value of the steering angle detecting apparatus 430 and an output value received from the encoder 420. Three parameters are non-linearity, hysteresis, and an error band. The calculator 440 receives the output value for 4 to 5 seconds at 10 ms intervals from each steering angle detecting apparatus and calculates a maximum value (max) and a minimum value (min) of three parameters.

The error band means a difference between an actual rotation angle of the rotary shaft and a rotation angle measured by the steering angle detecting apparatus 430. In an embodiment, the error band means a difference between the output value of the encoder 420 and the output value of the steering angle detecting apparatus 430.

The non-linearity is a value representing how linearly the rotation angle is measured by the steering angle detecting apparatus 430. The non-linearity is a difference between a trend line of values measured by the steering angle detecting apparatus 430 and each measured value.

The hysteresis means a maximum error range which may occur at one point, namely at a specific rotation angle.

If three parameters are closer to 0, it is determined that the product reliability is high.

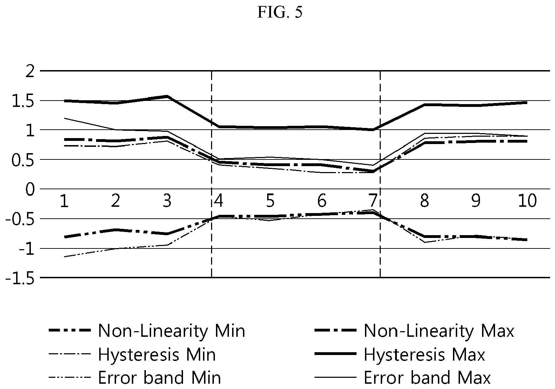

In detail, three parameters of ten steering angle detecting apparatuses as in Table 1 are as in Table 2 below. FIG. 5 is a graph of Table 2.

Table 2

| | Non-linearity | | Hysteresis | | Error band | |
|---|---|---|---|---|---|---|
| | Min | Max | Min | Max | Min | Max |
| Comparative Example 1 | -0.81 | 0.82 | 0.73 | 1.5 | -1.13 | 1.2 |
| Comparative Example 2 | -0.71 | 0.81 | 0.71 | 1.46 | -0.99 | 1 |
| Comparative Example 3 | -0.78 | 0.86 | 0.79 | 1.56 | -0.95 | 0.97 |
| Example 1 | -0.47 | 0.45 | 0.39 | 1.06 | -0.47 | 0.51 |
| Example 2 | -0.45 | 0.4 | 0.35 | 1.01 | -0.5 | 0.52 |
| Example 3 | -0.43 | 0.41 | 0.28 | 1.05 | -0.43 | 0.47 |
| Example 4 | -0.38 | 0.31 | 0.3 | 1 | -0.33 | 0.4 |
| Comparative Example 4 | -0.81 | 0.77 | 0.86 | 1.41 | -0.89 | 0.9 |
| Comparative Example 5 | -0.83 | 0.78 | 0.88 | 1.42 | -0.82 | 0.92 |
| Comparative Example 6 | -0.85 | 0.8 | 0.9 | 1.46 | -0.85 | 0.89 |

Referring to Tables 1 and 2 as well as FIG. 5, in Comparative Examples 1 to 6, the non-linearity has a minimum value (Min) of -0.71 or below and a maximum value (Max) of 0.77 or above. Meanwhile, in Examples 1 to 4, the non-linearity has a minimum value (Min) of -0.47 or above and a maximum value (Max) of 0.45 or below, which is closer to 0 in comparison to the comparative examples. In addition, if Comparative Examples 1 to 3 are compared with Example 1, when the area A becomes 334 mm$^2$ or above, the minimum value (Min) and the maximum value (Max) of the non-linearity become closer to 0 abruptly. In addition if Comparative Examples 4 to 6 are compared with Example 4, when the area A exceeds 528 mm$^2$, the minimum value (Min) and the maximum value (Max) of the non-linearity become farther from 0 abruptly.

In relation to the hysteresis, in Comparative Examples 1 to 6, the hysteresis has a minimum value (Min) of 0.71 or above and a maximum value (Max) of 1.41 or above. Meanwhile, in Examples 1 to 4, the hysteresis has a minimum value (Min) of 0.39 or below and a maximum value (Max) of 1.06 or below, which is closer to 0 in comparison to the comparative examples. In addition, if Comparative Examples 1 to 3 are compared with Example 1, when the area A becomes 334 mm$^2$ or above, the minimum value (Min) and the maximum value (Max) of the hysteresis become closer to 0 abruptly. In addition if Comparative Examples 4 to 6 are compared with Example 4, when the area A exceeds 528 mm$^2$, the minimum value (Min) and the maximum value (Max) of the hysteresis become farther from 0 abruptly.

In relation to the error band, in Comparative Examples 1 to 6, the error band has a minimum value (Min) of -0.82 or below and a maximum value (Max) of 0.89 or above. Meanwhile, in Examples 1 to 4, the error band has a minimum value (Min) of -0.5 or above and a maximum value (Max) of 0.52 or below, which is closer to 0 in comparison to the comparative examples. In addition, if Comparative Examples 1 to 3 are compared with Example 1, when the area A becomes 334 mm$^2$ or above, the minimum value (Min) and the maximum value (Max) of the error band become closer to 0 abruptly. In addition if Comparative Examples 4 to 6 are compared with Example 4, when the area A exceeds 528 mm$^2$, the minimum value (Min) and the maximum value (Max) of the error band become farther from 0 abruptly.

Thus, it may be understood that an optimal mode, namely a best mode, is obtained when the area A of the triangle obtained by connecting the center points of three gears 210, 230, 240 of the steering angle detecting apparatus is 334 mm$^2$ or above and 528 mm$^2$ or below. At this time, seeing Table 1, the distance R1 between the centers of the main gear 210 and the sub gear 230 is preferably 27 mm or above and 38 mm or below. In addition, the distance R2 between the centers of the main gear 210 and the sub gear 240 is preferably 27.5 mm or above and 38.5 mm or below.

In addition, the distance L between the centers of the sub gear 230 and the sub gear 240 is preferably 25 mm or above and 35 mm or below.

It should be understood by those skilled in the art that many adaptations, modifications and changes may be made to the present disclosure without departing from the scope of the claims, and the present disclosure described hereinabove is not limited by the disclosed embodiments and the accompanying drawings.

**Claims**

1. A steering angle detecting apparatus, which detects a rotation angle of a steering wheel, the apparatus comprising a main gear (210) configured to rotate in association with a steering shaft connected to the steering wheel, and two sub gears (230, 240) respectively having a magnet and configured to rotate in engagement with the main gear (210), **characterized in that**
a triangle obtained by connecting centers of the main gear (210) and two sub gears (230, 240) has an area of 334 mm2 or above and 528 mm2 or below.

2. The steering angle detecting apparatus according to claim 1,
wherein a distance between the centers of the main gear (210) and any one sub gear of two sub gears (230, 240) is 27 mm or above and 38 mm or below, and
wherein a distance between the centers of the main gear (210) and another sub gear of two sub gears (230, 240) is 27.5 mm or above and 38.5 mm or below.

3. The steering angle detecting apparatus according to claim 2,
wherein a distance between the centers of two sub gears is 25 mm or above and 35 mm or below.

**Patentansprüche**

1. Steuerwinkelerfassungsvorrichtung, die einen Drehwinkel eines Steuerrades erfasst, wobei die Vorrichtung ein Hauptzahnrad (210), das dazu konfiguriert ist, gemeinsam mit einer Steuerwelle zu rotieren, die mit dem Steuerrad verbunden ist, und zwei Unterzahnräder (230, 240) aufweist, die jeweils mit einem Magnet ausgestattet und dazu konfiguriert sind, im Eingriff mit dem Hauptzahnrad (210) zu rotieren, **dadurch gekennzeichnet, dass**
ein Dreieck, das man durch Verbindung der Mittelpunkte des Hauptzahnrads (210) und der zwei Unterzahnräder (230, 240) erhält, eine Fläche von 334 mm$^2$ oder mehr und 528 mm$^2$ oder weniger aufweist.

2. Steuerwinkelerfassungsvorrichtung nach Anspruch 1,
wobei ein Abstand zwischen den Mittelpunkten des Hauptgetriebes (210) und irgendeinem Unterzahnrad der zwei Unterzahnräder (230, 240) 27 mm oder mehr und 38 mm oder weniger beträgt, und
wobei ein Abstand zwischen den Mittelpunkten des Hauptzahnrades (210) und einem anderen Unterzahnrad der zwei Unterzahnräder (230, 240) 27,5 mm oder mehr und 38,5 mm oder weniger beträgt.

3. Steuerwinkelerfassungsvorrichtung nach Anspruch 2,
wobei ein Abstand zwischen den Mittelpunkten von zwei Unterzahnrädern 25 mm oder mehr und 35 mm oder weniger beträgt.

**Revendications**

1. Appareil de détection d'angle de direction qui détecte un angle de rotation d'un volant de direction, l'appareil comprenant un engrenage principal (210) configuré pour tourner en association avec un arbre de direction connecté au volant de direction, et deux engrenages secondaires (230, 240) ayant chacun un aimant et étant configurés pour tourner en prise avec l'engrenage principal (210), **caractérisé en ce qu'**un triangle obtenu en reliant les centres de l'engrenage principal (210) et des deux engrenages secondaires (230, 240) présente une superficie de 334 mm$^2$ ou plus et de 528 mm$^2$ ou moins.

2. Appareil de détection d'angle de direction selon la revendication 1,
dans lequel une distance entre les centres de l'engrenage principal (210) et l'un quelconque parmi les deux engrenages secondaires (230, 240) est de 27 mm ou plus et de 38 mm ou moins, et

une distance entre les centres de l'engrenage principal (210) et un autre parmi les deux engrenages secondaires (230, 240) est de 27,5 mm ou plus et de 38,5 mm ou moins.

3. Appareil de détection d'angle de direction selon la revendication 2,
dans lequel une distance entre les centres de deux engrenages secondaires est de 25 mm ou plus et de 35 mm ou moins.

FIG. 1

FIG. 2

FIG. 3

210

211

230

231

d

$r_2$

$r_1$

FIG. 4

420 — ENCODER

410 — MOTOR

430 — STEERING ANGLE DETECTING APPARATUS

CALCULATOR ~ 440

FIG. 5

- - - - Non-Linearity Min       - - · - Non-Linearity Max
- - — - Hysteresis Min          —— Hysteresis Max
- - · · · - Error band Min      —— Error band Max

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1477389 A